# FASCICULE DE BREVET EUROPEEN

(11) **EP 2 776 364 B1**
(45) Date de publication et mention de la délivrance du brevet: **13.01.2016**
(21) Numéro de dépôt: 12786958.4
(22) Date de dépôt: 08.11.2012
(51) Int. Cl.: B81C 1/00, B06B 1/02

(54) **PROCEDE AMELIORE DE REALISATION D'UN DISPOSITIF A CAVITES FORMEES ENTRE UN ELEMENT SUSPENDU REPOSANT SUR DES PLOTS ISOLANTS SEMI-ENTERRES DANS UN SUBSTRAT ET CE SUBSTRAT**
VERBESSERTES VERFAHREN ZUR HERSTELLUNG EINER VORRICHTUNG MIT HOHLRÄUMEN ZWISCHEN EINEM AUFGEHÄNGTEN ELEMENT AUF IN EINEM SUBSTRAT HALBVERGRABENEN ISOLIERENDEN PADS UND DIESES SUBSTRAT
IMPROVED PROCESS FOR PRODUCING A DEVICE COMPRISING CAVITIES FORMED BETWEEN A SUSPENDED ELEMENT RESTING ON INSULATING PADS SEMI-BURIED IN A SUBSTRATE AND THIS SUBSTRATE

(30) Priorité: 09.11.2011 FR 1160208
(43) Date de publication de la demande: 17.09.2014
(73) Titulaire: Commissariat à l'Énergie Atomique et aux Énergies Alternatives, 75015 Paris (FR)
(72) Inventeur: LARREY, Vincent, F-38140 La Murette (FR); POLIZZI, Jean-Philippe, F-38000 Grenoble (FR)
(74) Mandataire: Ahner, Philippe
(86) Numéro de dépôt international: PCT/EP2012/072156
(87) Numéro de publication internationale: WO 2013/068474

(56) Documents cités:
- WO-A2-2006/134580
- US-A1- 2009 126 183

## Description

### DOMAINE TECHNIQUE

La présente invention se rapporte au domaine de la nano et de la microélectronique et concerne un procédé amélioré de réalisation d'un dispositif doté d'un ou plusieurs espaces ou cavités formé(e)(s) entre un élément suspendu, tel que par exemple une membrane ou une poutre, et un substrat, l'élément suspendu étant maintenu au dessus du substrat par le biais de plots isolants.

L'invention permet de réaliser un dispositif dans lequel la hauteur de la ou des cavités est réglée indépendamment de celle des plots isolants.

L'invention permet également de réaliser un dispositif avec des cavités hauteurs différentes.

Elle trouve des applications notamment dans le domaine de la réalisation de NEMS/MEMS (NEMS pour « Nano Electro Mechanical Systems » et MEMS pour « Micro Electro Mechanical Systems ») et en particulier de transducteurs électroacoustiques tels que les transducteurs cMUTs « Capacitive Micromachined Ultrasonic Transducers ».

### ART ANTÉRIEUR

Un transducteur MEMS est généralement formé d'une partie fixe dotée d'une électrode qui peut être formée dans un substrat semi-conducteur 10, et d'une membrane 40 formant une électrode mobile.

La membrane 40 repose sur des plots isolants 14a, 14b et réalise avec la partie fixe une cavité 50 dans laquelle elle est destinée à vibrer.

Dans un tel transducteur, des déplacements de la membrane 40 créés par des ondes acoustiques sont traduits en signaux électriques, tandis que des signaux électriques appliqués sur l'électrode mobile et l'électrode fixe peuvent permettre d'actionner la membrane 40.

La hauteur H₁ de la cavité 50 séparant le substrat 10 de la membrane 40 est généralement fixée par la hauteur H₂ des plots 14a, 14b isolants. Pour permettre une bonne isolation et afin de réduire les phénomènes de capacité parasite, il est préférable de réaliser des plots isolants de hauteur H₂ importante.

Dans le même temps, pour des raisons d'efficacité de fonctionnement, et pour certaines applications, il est également préférable de réaliser des cavités de hauteur H₁ faible. Une hauteur de cavité faible permet de mettre en oeuvre un actionnement de la membrane 40 à l'aide de tensions de commande faibles, et d'avoir plus de signal lorsque le dispositif est en mode de détection.

Le document US 2009/0142872 présente un procédé de fabrication d'un transducteur cMUT dans lequel les plots isolants destinés à maintenir la membrane sont formés par oxydation du substrat semi-conducteur.

Un tel procédé peut permettre de réaliser des plots isolants qui sont partiellement enfouis dans le substrat. On peut ainsi former des plots isolants de hauteur importante, tout en limitant la hauteur de la cavité. Cependant, avec un tel procédé, la hauteur de la cavité reste dépendante de celle des plots isolants.

Le document WO 2006/134580 A2 présente un procédé de réalisation d'un transducteur MEMS dans lequel des plots isolants sont disposés à différentes profondeurs de la face externe d'un substrat, une membrane étant rattachée à certains de ces plots.

Avec un tel procédé, la hauteur des cavités reste également dépendante de celle des plots isolants.

Il se pose le problème de trouver un nouveau procédé qui ne comporte pas les inconvénients mentionnés ci-dessus, permette de réaliser un dispositif MEMS comportant à la fois des plots isolants de hauteur importante tout en conservant une cavité de faible hauteur.

Il se pose également le problème de trouver un nouveau procédé qui permette de réaliser des cavités de hauteurs différentes.

### EXPOSÉ DE L'INVENTION

La présente invention prévoit un procédé de réalisation d'un dispositif comprenant un-ou plusieurs espaces tels que des cavités défini(e)s entre un substrat à base d'au moins un matériau semi-conducteur donné et un élément suspendu reposant sur le sommet de plots isolants dépassant du substrat, le procédé comprenant des étapes de :
a) réalisation de plots isolants de part et d'autre d'une ou plusieurs zones d'une face supérieure d'un substrat à base d'au moins un matériau semi-conducteur donné,
b) modification, par au moins une gravure et/ou au moins un ajout de matière, de la distance entre au moins une zone donnée parmi lesdites zones de ladite face supérieure et le sommet de plots isolants situés de part et d'autre de ladite zone donnée, lesdits plots isolants comportant à l'issue de l'étape b) au moins une partie située dans le substrat et entourée par ledit matériau semi-conducteur donné,
c) formation de l'élément suspendu sur le sommet desdits plots isolants.

A l'étape b), la matière ajoutée est semi-conductrice.

Avec un tel procédé on fixe tout d'abord la hauteur des plots isolants qui sont partiellement enfouis ou insérés dans le substrat, puis on fixe la hauteur d'une ou plusieurs cavités formées entre l'élément suspendu et le substrat, en ajoutant ou retirant de la matière au substrat après avoir réalisé les plots.

On peut ainsi former un dispositif avec des cavités de faible hauteur, par exemple comprise entre 10 nm et 5 µm, tout en conservant une épaisseur importante des plots isolants, par exemple entre 0.1 µm et 10 µm.

Le procédé à l'étape b) peut comprendre au moins une gravure de ladite zone donnée à travers un masquage protégeant au moins une autre zone parmi lesdites zones de la face supérieure du substrat.

Selon une variante, l'étape b) peut comprendre une croissance par épitaxie de matériau semi-conducteur sur au moins ladite zone donnée de ladite face supérieure du substrat.

La présente invention prévoit également un procédé de réalisation d'un dispositif comprenant plusieurs espaces tels que des cavités définies entre un substrat à base d'au moins un matériau semi-conducteur donné et un élément suspendu reposant sur le sommet de plots isolants dépassant du substrat, le procédé comprenant des étapes de :
a) réalisation de plots isolants de part et d'autre d'une ou plusieurs zones d'une face supérieure d'un substrat à base d'au moins un matériau semi-conducteur donné,
b) modification, par au moins une gravure et/ou au moins un ajout de matière semi-conductrice, de la distance entre au moins une zone donnée parmi lesdites zones de ladite face supérieure et le sommet de plots isolants situés de part et d'autre de ladite zone donnée, un masquage protégeant au moins une autre zone parmi lesdites zones de la face supérieure du substrat, lesdits plots isolants comportant à l'issue de l'étape b) au moins une partie située dans le substrat et entourée par ledit matériau semi-conducteur donné,
c) formation de l'élément suspendu sur le sommet desdits plots isolants.

On réalise ainsi des cavités de hauteurs différentes entre le substrat et la membrane.

L'étape c) de formation de l'élément suspendu peut comprendre le report par collage directe de la membrane sur les plots

On peut ensuite effectuer un amincissement de la membrane après report.

Le substrat peut former une première électrode ou comporter une première électrode, par exemple d'actionnement et/ou de mesure.

L'élément suspendu, par exemple une poutre ou une membrane, peut former une deuxième électrode ou comporter une deuxième électrode, par exemple d'actionnement et/ou de mesure.

Selon une possibilité de mise en oeuvre, les plots isolants peuvent être formés d'une base en un matériau donné qui n'est pas nécessairement isolant, et d'un sommet à base d'un matériau isolant et permettant d'isoler électriquement le substrat et l'élément suspendu.

Selon une possibilité, la présente invention peut s'appliquer à la réalisation d'un MEMS ou NEMS.

La présente invention peut s'appliquer en particulier à la réalisation d'un transducteur cMUT.

La dite zone donnée peut être entourée par un plot isolant ou plusieurs plots isolants contigus à cette zone.

Selon une mise en oeuvre particulière, la dite zone donnée peut être totalement entourée par un ou plusieurs desdits plots isolants.

Selon une possibilité de mise en oeuvre, lesdits plots peuvent être régulièrement répartis et agencés selon une matrice.

Le procédé peut comprendre à l'étape a) des étapes de :
- gravure de la face supérieure du substrat de manière à former des blocs semi-conducteurs,
- formation de plots isolants de part et d'autre desdits blocs semi-conducteurs.

Selon une première possibilité de mise en oeuvre, la formation desdits plots isolants peut comporter des étapes de :
- dépôt conforme de matériau isolant sur et autour desdits blocs semi-conducteurs,
- retrait du matériau isolant dans une zone située au dessus des blocs semi-conducteurs,

La hauteur des plots isolants est ainsi fixée en fonction de celle des blocs semi-conducteurs.

Selon une deuxième possibilité de mise en oeuvre, la formation desdits plots isolants peut comporter des étapes de :
- gravure de la face supérieure du substrat de manière à réaliser des blocs semi-conducteurs, les blocs semi-conducteurs étant recouverts d'un masque à oxydation,
- oxydation du matériau semi-conducteur donné du substrat.

Selon une autre possibilité, la formation desdits plots isolants comporte la gravure d'une couche isolante reposant sur le substrat, de manière à définir des plots isolants reposant sur le substrat.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de transducteur cMUT suivant l'art antérieur comportant une cavité réalisée entre une membrane et un substrat,
- les figures 2A-2E illustrent un premier exemple de procédé de réalisation suivant l'invention d'un dispositif doté de plusieurs cavités fermée(s) entre une membrane et un substrat,
- les figures 3A-3D, et 6A-6B illustrent un deuxième exemple de procédé de réalisation suivant l'invention d'un dispositif doté de plusieurs cavités fermée(s) entre une membrane et un substrat,
- les figures 4A-4E illustrent un troisième exemple de procédé de réalisation suivant l'invention d'un dispositif doté de plusieurs cavités fermée(s) entre une membrane et un substrat,
- les figures 5A-5D illustrent différents agencements de plots isolants mis en oeuvre au cours d'un procédé suivant l'invention et destinés à porter un élément suspendu.

### EXPOSÉ DÉTAILLÉ DE MODES DE RÉALISATION PARTICULIERS

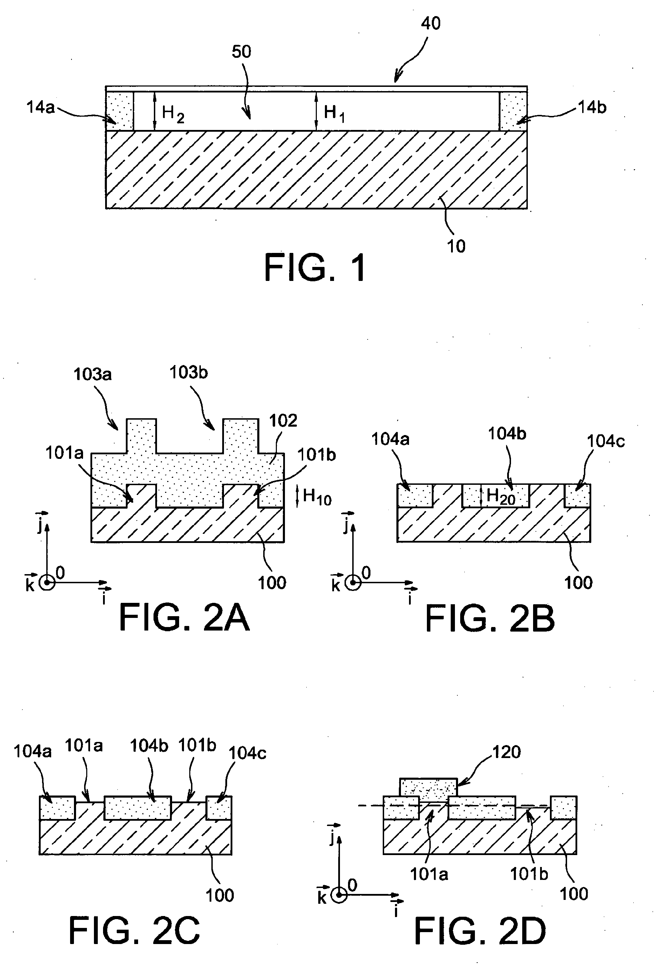

Un premier exemple de procédé suivant l'invention va à présent être décrit en liaison avec les figures 2A-2E.

Le matériau de départ de ce procédé est un substrat 100 qui peut être à base de matériau semi-conducteur, par exemple tel que du Si, et comporte des zones 101a, 101b sous forme de blocs créés sur une face dite « face supérieure » du substrat 100.

Le substrat 100 peut être destiné à former une électrode ou comporter une zone destinée à former une électrode, notamment dans le cas où le dispositif qui est réalisé est un MEMS ou un NEMS, en particulier un transducteur cMUT.

Ces blocs peuvent avoir été réalisés par gravure de la face supérieure du substrat 100, par exemple une gravure anisotrope à travers un masquage.

La gravure peut être réalisée par exemple par gravure dite « sèche » à base de plasma réactif RIE (RIE pour « Reactive Ion Etch ») ou DRIE (DRIE pour « Deep Reactive Ion Etch ») ou par gravure dite « humide », par voie chimique à l'aide de réactifs tels que par exemple du KOH ou du TMAH.

Une couche isolante 102 est ensuite réalisée sur le substrat 100. Cette couche isolante 102 peut être par exemple à base de SiO₂ et réalisée par dépôt conforme, de sorte qu'elle reproduit le relief de la face supérieure du substrat 100.

La couche isolante 102 formée peut ainsi comporter des zones 103a, 103b formant des blocs reproduisant la forme des blocs semi-conducteurs 101a, 101b, en surface du substrat 100 (figure 2A).

On effectue ensuite une étape d'aplanissement ou communément appelée de « planarisation » des zones 103a, 103b de la couche isolante 102, par exemple par polissage de type CMP (CMP pour « Chemical Mechanical Planarization ») ou par gravure. On rend ainsi la surface de la couche isolante 102 plane ou sensiblement plane. L'épaisseur de la couche isolante 102 dépassant du sommet des zones 101a, 101b peut être également retirée. On forme ainsi des plots isolants 104a, 104b, 104c, issus de la couche isolante 102 et qui peuvent avoir une hauteur H₂₀ (mesurée dans une direction parallèle au vecteur *̅j̅*̅ du repère orthogonal [O;*̅i̅*̅; *̅j̅*̅ ;*̅k̅*̅] donné sur la figure 2B) égale à la hauteur H₁₀ des zones semi-conductrices 101a, 101b. La hauteur H₂₀ des plots isolants peut être comprise par exemple entre 0.1 µm et 10 µm.

Les plots isolants 104a, 104b, 104c, peuvent être ainsi réalisés de manière à être enfouis dans le substrat 100. Les plots isolants 104a, 104b, 104c, peuvent être situés intégralement dans le substrat 100, le sommet des plots isolants 104a, 104b, 104c, et la face supérieure du substrat 100 étant situés à la même hauteur. Les flancs des plots isolants 104a, 104b, 104c sont ainsi entourés par le matériau semi-conducteur du substrat 100.

On effectue ensuite un retrait d'une épaisseur de la face supérieure du substrat 100, par exemple par gravure de ce dernier à l'aide d'un plasma.

Cette gravure est réalisée de manière à dévoiler une partie des flancs des plots isolants 104a, 104b, 104c.

La partie inférieure des plots isolants 104a, 104b, 104c est ainsi entourée par le matériau semi-conducteur du substrat 100 tandis qu'une partie supérieure de ces derniers est dévoilée et dépasse de la face supérieure du substrat 100 (figure 2C).

On peut ensuite effectuer une gravure d'au moins une zone 101b donnée parmi lesdites zones semi-conductrices 101a, 101b, de la face supérieure du substrat 100 qui sont dévoilées. Cette gravure est alors réalisée à travers un masquage 120 protégeant au moins une autre zone 101a parmi lesdites zones semi-conductrices 101a, 101b. On retire ainsi une épaisseur de la zone donnée 101b du substrat 100, qui n'est pas protégée par le masquage 120 (figure 2D).

Ces étapes de retrait peuvent etre réalisées par une gravure sélective vis-à-vis du matériau de la couche isolante 102. Cette gravure sélective peut être effectuée par exemple par voie plasma de type RIE ou DRIE lorsque les zones 101a, 101b du substrat 100 sont à base de Si et que la couche isolante 102 est à base de SiO₂.

Par cette gravure, on ajuste la distance entre le sommet des plots 104b, 104c isolants et la ou les zone(s) donnée 101a et 101b. On peut ajuster ainsi la hauteur d'une cavité ou d'une portion de cavité destinée à être réalisée ultérieurement entre ces zones données de la face supérieure du substrat et une membrane reposant sur le sommet des plots isolants 104.

Cette étape d'ajustement de la hauteur du sommet des plots 104a, 104b, 104c par rapport à la face supérieure du substrat 100 peut être réalisée au moyen de plusieurs gravures successives lorsque plusieurs hauteurs de cavité sont désirées.

En variante, on peut effectuer cet ajustement par épitaxie sélective, c'est-à-dire par épitaxie sur la zone 101b, à travers un masquage 120 protégeant au moins une autre zone 101a parmi lesdites zones semi-conductrices 101a, 101b.

On peut ensuite former un élément suspendu, par exemple une membrane 140. La membrane 140 peut être par exemple à base de silicium monocristallin reposant sur les plots isolants 104a, 104b, 104c. La membrane 140 peut être destinée à former une électrode ou comporte une zone destinée à former d'électrode. Cette membrane 140 peut être réalisée par report sur les plots 104a, 104b, 104c, par exemple en effectuant un collage direct sur ces derniers.

Une étape d'amincissement de la membrane 140 peut être ensuite réalisée. Cet amincissement pourra faire intervenir seule ou en combinaison, une ou plusieurs des techniques suivantes : gravure chimique, et/ou gravure sèche, et/ou rodage (grinding), et/ou polissage mécano-chimique (CMP).

Entre cette membrane 140 reposant sur les plots isolants 104a, 104b, 104c, et le substrat 100, une ou plusieurs cavités 150a, 150b fermée(s) peuvent être réalisées.

Un premier espace, dans cet exemple une première cavité 150a ou portion de cavité 150a peut être définie entre une première zone 101a du substrat 100 et la membrane 140, ainsi qu'entre les plots isolants 104a, 104b. Cette première cavité 150a ou portion de cavité 150a peut avoir une hauteur H₁₁ par exemple comprise entre 10 nm et 5 µm, ou par exemple de l'ordre de 100 nm.

Selon une possibilité de réalisation, cette première cavité 150a peut être éventuellement fermée de sorte qu'elle ne communique pas vers l'extérieur ou vers une autre cavité.

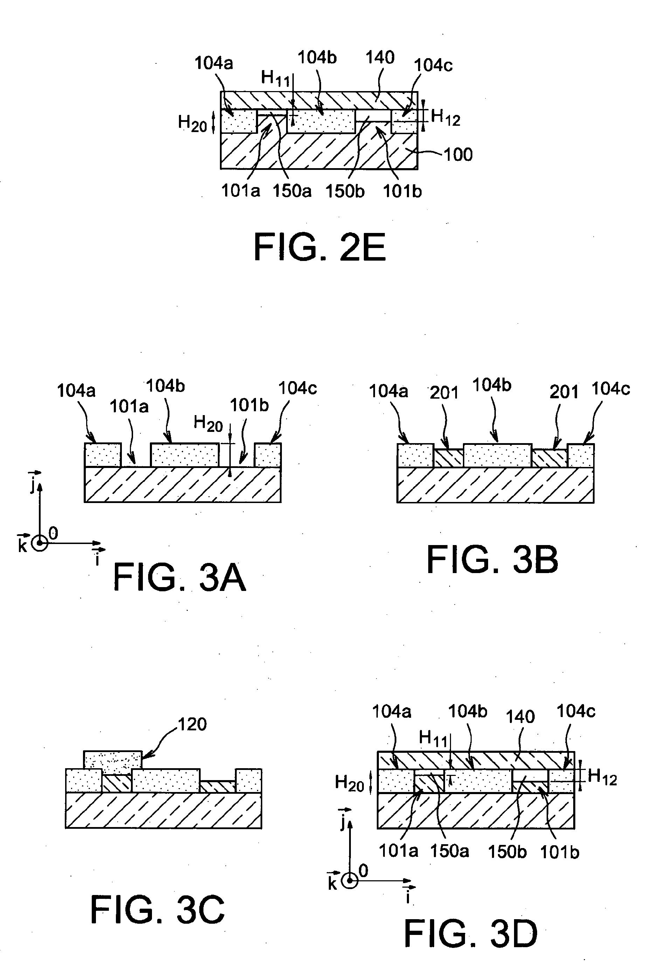

Un deuxième espace, dans cet exemple une deuxième cavité 150b ou portion de cavité 150b définie entre la zone 101b donnée du substrat 100 et la membrane 140 et entre les plots isolants 104b, 104c peut être également réalisée. Cette deuxième cavité 150b ou portion de cavité 150b peut avoir une deuxième hauteur H₁₂ différente de la première hauteur H₁₁, et par exemple comprise entre 50 nm et 5 µm, ou par exemple de l'ordre de plusieurs centaines de nanomètres. Selon une possibilité de réalisation, cette deuxième cavité 150b peut être éventuellement fermée de sorte qu'elle ne communique pas vers l'extérieur ou vers une autre cavité (figure 2E).

Un autre exemple de procédé suivant l'invention est illustré sur les figures 3A-3D.

Le matériau de départ de ce procédé est un substrat 100 recouvert d'une couche isolante 102 dans laquelle des plots 104a, 104b, 104c distincts de hauteur H₂₀, sont réalisés par exemple par gravure. La couche isolante 102 peut être par exemple à base de SiO₂ ou d'un matériau diélectrique « low-k » tel que par exemple du SiOC (figure 3A). La hauteur H₂₀ des plots 104a, 104b, 104c (mesurée dans une direction parallèle au vecteur *̅j̅*̅ du repère orthogonal [O;*̅i̅*̅; *̅j̅*̅ ; *̅k̅*̅] donné sur la figure 3A) peut être comprise par exemple entre 0,1 µm et 10 µm.

Des zones 101a, 101b d'une face du substrat 100 appelée « face supérieure » et qui sont situées entre les plots 104a, 104b, 104c isolants sont ainsi dévoilées.

On forme ensuite une épaisseur supplémentaire de matériau semi-conducteur 201 sur ces zones 101a, 101b par croissance épitaxiale sélective.

On ajuste ainsi la distance entre le sommet des plots isolants 104a, 104b, 104c et les zones 101a, 101b de la face supérieure du substrat 100 (figure 3B).

On peut effectuer ensuite une gravure d'au moins une zone 101b donnée parmi lesdites zones semi-conductrices 101a, 101b. Cette gravure peut être réalisée, par exemple par gravure sèche de type RIE ou DRIE à travers un masquage 120 protégeant au moins une autre zone 101a parmi lesdites zones semi-conductrices 101a, 101b.

On peut ainsi ajuster la hauteur d'une cavité 150b ou d'une portion de cavité qui peut être formée par la suite entre la zone donnée 101b du substrat 100 et une membrane, et rendre la hauteur H₁₂ de cette cavité 150b plus importante que celle H₁₁ d'une autre portion de cavité ou d'une autre cavité 150a formée par la suite entre la zone 101a du substrat 100 et une membrane.

Cette membrane 140 peut être ensuite réalisée notamment par collage sur les plots isolants 104a, 104b, 104c de manière semblable à celle décrite précédement.

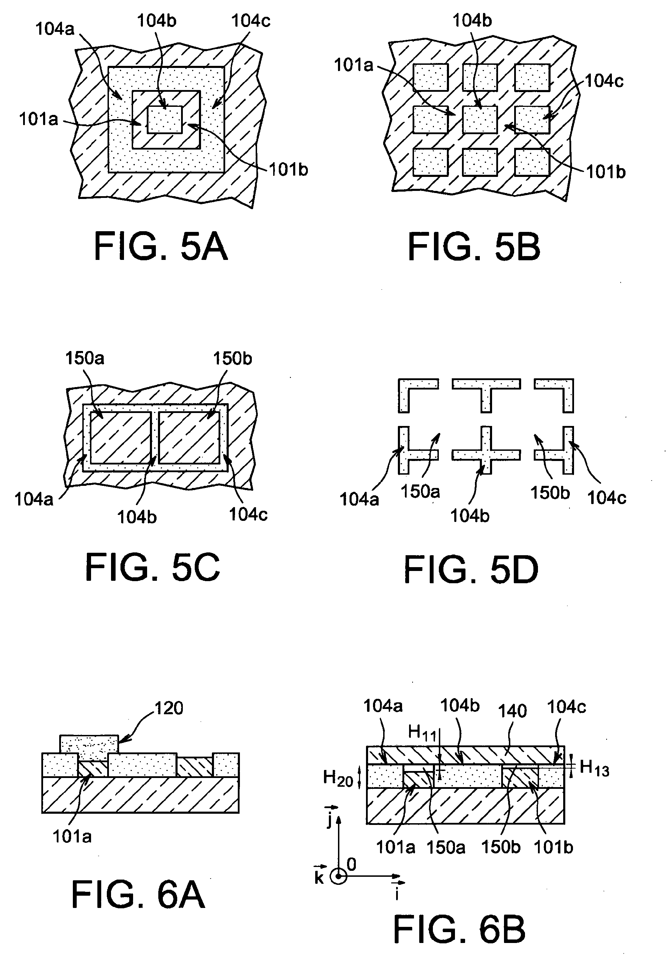

En variante (figures 6A-6B), après l'étape décrite précédemment en liaison avec la figure 3B, on peut effectuer ensuite une croissance par épitaxie sélective de matériau semi-conducteur sur au moins une zone 101b donnée parmi lesdites zones semi-conductrices 101a, 101b. Cet ajout de matière semi-conductrice est réalisé à travers un masquage 120 protégeant au moins une autre zone 101a parmi lesdites zones semi-conductrices 101a, 101b (figure 6A).

On peut ainsi ajuster la hauteur d'une cavité 150b ou d'une portion de cavité qui peut être formée par la suite entre la zone donnée 101b du substrat 100 et une membrane 140, et rendre la hauteur H₁₃ de cette cavité 150b plus faible que celle H₁₁ d'une autre portion de cavité ou d'une autre cavité 150a formée entre l'autre zone 101a du substrat 100 et la membrane 140 (figure 6B).

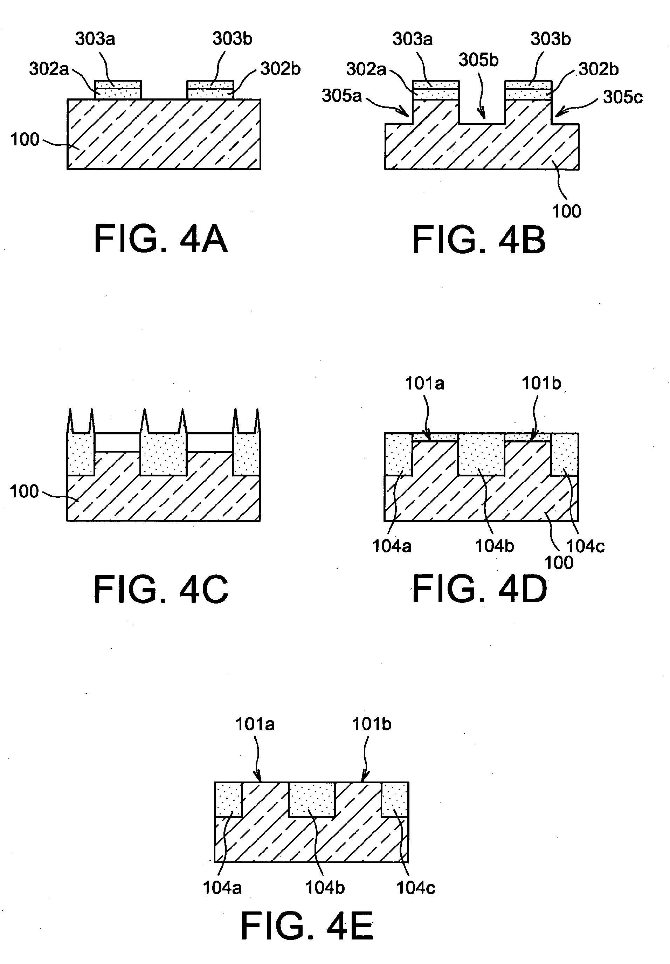

Un autre exemple de procédé suivant l'invention est illustré sur les figures 4A-4E.

Le matériau de départ de cet exemple de procédé peut être un substrat semi-conducteur 100 sur lequel des zones isolantes 302a, 302b sont formées. Ces zones isolantes 302a, 302b peuvent être par exemple à base de SiO₂ et recouvertes respectivement de zones de masquage à oxydation 303a, 303b, par exemple à base de Si₃N₄ (figure 4A).

On effectue ensuite une gravure anisotrope, par exemple de type RIE ou DRIE, d'une face du substrat 100 dite « face supérieure » à travers les zones de masquage 303a, 303b empilées respectivement sur les zones isolantes 302a, 302b.

Cette gravure est réalisée de manière à former des tranchées 305a, 305b, 305c dans le substrat, des blocs 301a, 301b du substrat 100 étant disposés de part et d'autre des tranchées (figure 4B).

La profondeur des tranchées 305a, 305b, 305c est ajustée en fonction de celle que l'on souhaite prévoir pour des plots isolants destinés à être réalisés ultérieurement.

Ensuite, on effectue une oxydation thermique du matériau semi-conducteur du substrat 100 de manière à combler les tranchées de matériau isolant.

Les tranchées remplies de matériau isolant ainsi que des zones oxydées du substrat situées dans le prolongement de ces tranchées, forment des plots isolants 104a, 104b, 104c dont une partie inférieure est enfouie dans le substrat 100 et situé d'un côté de la face supérieure de ce dernier, la partie supérieure des plots 104a, 104b, 104c dépassant de la face supérieure du substrat 100. L'épaisseur d'oxyde créé peut être telle que la surface supérieure de l'oxyde créé affleure au même niveau, ou sensiblement au même niveau que les masques 303a, 303b à oxydation. Par sensiblement au même niveau, on entend par exemple selon un écart d'au plus 10 nm ou 50 nm.

Lorsque les zones de masquage à oxydation 303a, 303b sont prévues par exemple à base de Si₃N₄, à l'issue de l'oxydation (figure 4C), ces zones peuvent être transformées en SiOₓN_{y}. Ces zones à base de SiOₓN_{y} ont avantageusement un comportement proche de celui du SiO₂, lors d'une étape de planarisation ultérieure, par exemple par CMP.

Les zones de masquage à oxydation 303a, 303b peuvent avoir été choisies avec une épaisseur initiale suffisamment faible, par exemple de l'ordre de 100 nm, pour être transformées par oxydation, et en particulier être transformées en SiOₓN_{y} lorsqu'initialement ces zones étaient à base de Si₃N₄.

Une planarisation, par exemple par polissage mecano-chimique (CMP) est ensuite réalisée pour enlever des surépaisseurs de matériau isolant. A l'issue de ce retrait, on obtient un substrat 100 comportant sur sa face supérieure des zones semi-conductrices 101a, 101b, ainsi que des plots isolants 104a, 104b, 104c disposés de part et d'autre de ces zones semi-conductrices 101a, 101b, et agencés de manière à comporter une partie inférieure enfouie dans le substrat 100 et qui est ainsi entourée par le matériau semi-conducteur du substrat 100 (figure 4E).

On peut ensuite effectuer un procédé tel que décrit précédemment en liaison avec les figures 2C-2E, afin de réaliser un dispositif à une ou plusieurs cavité(s) fermée(s) par une membrane soutenue par les plots isolants 104a, 104b, 104c.

Sur les figures 5A-5D, différents agencements de plots isolants 104a, 104b, 104c, réalisés au cours de l'un ou l'autre des procédés précédemment décrits et destinés à soutenir la membrane 140 sont donnés en vue de dessus.

Sur la figure 5A, les plots 104a, 104b, sont contigus à une zone 101a, de la face supérieure du substrat 100, tandis que les plots 104b, 104c, sont contigus à une autre zone 101b, de la face supérieure du substrat 100, les zones 101a et 101b étant totalement entourées par les plots isolants 104a, 104c.

Un tel agencement permet de former une cavité fermée délimitée entre les plots isolants 104a, 104b, 104c, le substrat 100 et la membrane 140.

Sur la figure 5B, les plots 104a, 104b, 104c isolants font partie d'un agencement matriciel.

Un tel agencement permet quant à lui de former des cavités ouvertes.

Sur la figure 5C, les plots 104a, 104b, forment une première cavité 150a, tandis que les plots 104c, 104b, forment une deuxième cavité 150a, la première cavité 150a et la deuxième cavité 150b étant fermées et séparées entre elles par le plot 104b.

Sur la figure 5D, les plots 104a, 104b, sont disposés autour d'une première cavité 150a, tandis que les plots 104c, 104b, sont disposés autour d'une deuxième cavité 150b, la première cavité 150a et la deuxième cavité 150b étant ouvertes et communicant entre elles.

## Revendications

1. Procédé de réalisation d'un dispositif comprenant plusieurs espaces (150a, 150b) de hauteurs différentes définis entre un substrat (100) à base d'au moins un matériau semi-conducteur donné et un élément suspendu (140) reposant sur le sommet d'au moins un plot (104a, 104b, 104c) dépassant du substrat et isolant électriquement l'élément suspendu du substrat, le procédé comprenant des étapes de :
a) réalisation du ou des plots (104a, 104b, 104c) contigus à une ou plusieurs zones (101a, 101b) d'une face supérieure d'un substrat (100) à base d'au moins un matériau semi-conducteur donné,
b) modification, par au moins une gravure et/ou au moins un ajout de matière semi-conductrice, de la distance entre au moins une zone donnée (101b) parmi lesdites zones (101a, 101b) de ladite face supérieure et le sommet du ou des plots (104b, 104c) contigus à ladite zone donnée (101b), l'ajout de matière semi-conductrice et/ou la gravure étant réalisée(s) à travers un masquage (120) protégeant au moins une autre zone (101a) parmi lesdites zones (101a, 101b) de la face supérieure du substrat (100), lesdits plots comportant à l'issue de l'étape b) au moins une partie située dans le substrat et entourée par ledit matériau semi-conducteur donné,
c) formation d'un élément suspendu (140) sur le sommet du ou desdits plots.

2. Procédé selon la revendication 1, dans lequel la dite zone donnée est partiellement ou totalement entourée par un ou plusieurs desdits plots.

3. Procédé selon l'une des revendications 1 ou 2, dans lequel au moins un plot est disposé entre deux desdites zones.

4. Procédé selon l'une quelconque des revendications 1 à 3, dans lequel lesdits plots sont régulièrement répartis et agencés selon une matrice.

5. Procédé selon l'une des revendications 1 à 4, dans lequel l'étape a) comprend des étapes de :
- gravure de la face supérieure du substrat (100) de manière à former des blocs semi-conducteurs,
- formation de plots contigus auxdits blocs semi-conducteurs.

6. Procédé selon la revendication 5, la formation desdits plots à l'étape a) comportant des étapes de :
- dépôt conforme de matériau isolant sur et autour desdits blocs semi-conducteurs,
- retrait du matériau isolant dans une zone située au dessus des blocs semi-conducteurs,
l'étape b) comportant la gravure de tout ou partie des blocs de matériau semi-conducteur pour former lesdites zones.

7. Procédé selon la revendication 6, dans lequel la formation desdits plots isolants comporte des étapes de :
- gravure de la face supérieure du substrat (100) de manière à réaliser des blocs semi-conducteurs, les blocs semi-conducteurs étant recouverts d'un masque (303a, 303b) à oxydation,
- oxydation du matériau semi-conducteur donné du substrat (100).

8. Procédé selon l'une des revendications 1 à 7, dans lequel la formation desdits plots isolants comporte la gravure d'une couche isolante reposant sur le substrat, de manière à définir des plots isolants reposant sur le substrat (100).

9. Procédé selon l'une des revendications 1 à 8, le substrat formant une première électrode ou comportant une première électrode, l'élément suspendu formant une deuxième électrode ou comportant une deuxième électrode.

10. Procédé selon l'une des revendications 1 à 9, le dispositif étant un NEMS/MEMS.

11. Procédé selon l'une des revendications 1 à 10, le dispositif étant un transducteur cMUT.

12. Procédé selon l'une des revendications 1 à 11, dans lequel l'étape c) de formation de l'élément suspendu comprend le report par collage directe d'une membrane sur lesdits plots.

13. Procédé selon la revendication 12, dans lequel on effectue un amincissement de la membrane après report.

14. Procédé selon l'une quelconque des revendications 1 à 13 dans lequel l'ajout de matière comprend une croissance par épitaxie de matériau semi-conducteur.

## Patentansprüche

1. Verfahren zur Herstellung einer Vorrichtung, umfassend mehrere Räume (150a, 150b) mit festgelegter unterschiedlicher Höhe zwischen einem Substrat (100) auf der Basis wenigstens eines gegebenen Halbleitermaterials und eines aufgehängten Elements (140), das auf dem Scheitelpunkt wenigstens einer überstehenden Kontaktstelle (104a, 104b, 104c) des Substrats ruht und das aufgehängte Element elektrisch von dem Substrat isoliert, wobei das Verfahren die folgenden Schritte umfasst:
a) Herstellen der Kontaktstelle/n (104a, 104b, 104c) benachbart einem oder mehreren Bereichen (101a, 101b) einer Oberfläche eines Substrats (100) auf der Basis wenigstens eines gegebenen Halbleitermaterials,
b) Modifizieren des Abstands zwischen wenigstens einem gegebenen Bereich (101 b) aus den Bereichen (101a, 101b) der Oberfläche und des Scheitelpunkts der an den gegebenen Bereich (101b) angrenzenden Kontaktstelle/n (104b, 104c) durch wenigstens eine Gravur und/oder wenigstens einen Zusatz von Halbleitermaterial, wobei der Zusatz von Halbleitermaterial und/oder die Gravur durch eine Maskierung (120) ausgeführt sind, welche wenigstens einen anderen Bereich (101a) aus den Bereichen (101 a, 101b) der Oberfläche des Substrats (100) schützt, wobei die Kontaktstellen am Ende von Schritt b) wenigstens einen Teil aufweisen, der in dem Substrat angeordnet und von dem gegebenen Halbleitermaterial umgeben ist,
c) Bilden eines aufgehängten Elements (140) auf dem Scheitelpunkt der Kontaktstelle/n.

2. Verfahren nach Anspruch 1, bei welchem der gegebene Bereich teilweise oder vollständig von einer oder mehreren Kontaktstellen umgeben wird.

3. Verfahren nach einem der Ansprüche 1 oder 2, bei welchem wenigstens eine Kontaktstelle zwischen zwei Bereichen angeordnet wird.

4. Verfahren nach einem der Ansprüche 1 bis 3, bei welchem die Kontaktstellen gleichmäßig verteilt und gemäß einer Matrix angeordnet werden.

5. Verfahren nach einem der Ansprüche 1 bis 4, bei welchem der Schritt a) die folgenden Schritte umfasst:
- Gravur der Oberfläche des Substrats (100) zur Bildung von Halbleiterblöcken,
- Bildung von an die Halbleiterblöcke angrenzenden Kontaktstellen.

6. Verfahren nach Anspruch 5, wobei die Bildung der Kontaktstellen in Schritt a) die folgenden Schritte umfasst:
- entsprechende Ablage von Isoliermaterial auf und um die Halbleiterblöcke herum,
- Reduzieren des Isoliermaterial in einem Bereich oberhalb der Halbleiterblöcke, wobei der Schritt b) die Gravur der gesamten oder eines Teils der Blöcke aus Halbleitermaterial zum bilden dieser Bereiche umfasst.

7. Verfahren nach Anspruch 6, bei welchem die Bildung der Isolierstellen die folgenden Schritte umfasst:
- Gravur der Oberfläche des Substrats (100) zur Herstellung von Halbleiterblöcken, wobei die Halbleiterblöcke mit einer Oxidationsmaske (303a, 303b) bedeckt werden,
- Oxidation des gegebenen Halbleitermaterials des Substrats (100).

8. Verfahren nach einem der Ansprüche 1 bis 7, bei welchem die Bildung der Isolierstellen die Gravur einer auf dem Substrat befindlichen Isolierschicht derart umfasst, dass auf dem Substrat (100) befindliche Isolierstellen begrenzt werden.

9. Verfahren nach einem der Ansprüche 1 bis 8, wobei das Substrat eine erste Elektrode bildet oder eine erste Elektrode umfasst, wobei das aufgehängte Element eine zweite Elektrode bildet oder eine zweite Elektrode umfasst.

10. Verfahren nach einem der Ansprüche 1 bis 9, wobei die Vorrichtung ein NEMS/MEMS ist.

11. Verfahren nach einem der Ansprüche 1 bis 10, wobei die Vorrichtung ein CMUT-Wandler ist.

12. Verfahren nach einem der Ansprüche 1 bis 11, bei welchen der Schritt c) die Bildung des aufgehängten Elements das Auftragen einer Membran auf die Kontaktstellen durch direkte Bindung beinhaltet.

13. Verfahren nach Anspruch 12, bei welchem eine Verdünnung der Membran nach dem Auftragen ausgeführt wird.

14. Verfahren nach einem der Ansprüche 1 bis 13, bei welchem der Materialzusatz ein Wachstum durch Epitaxie des Halbleitermaterials umfasst.

## Claims

1. A method for producing a device comprising several gaps (150a, 150b) of different height defined between a substrate (100) in at least one given semiconductor material and a suspended element (140) resting on the top of at least one post (104a, 104b, 104c) projecting from the substrate and electrically insulating the suspended element from the substrate, the method comprising steps of:
a) forming one or more posts (104a, 104b, 104c) contiguous with one or more regions (101a, 101b) of an upper surface of a substrate (100) in at least one given semiconductor material;
b) modifying, via at least one etching and/or at least one addition of semiconductor material, the distance between at least one given region (101b) from among the said regions (101a, 101b) of the said upper surface and the top of the post(s) (104b, 104c) contiguous with said given region (101b), the addition of semiconductor material and/or etching being conducted through a mask (120) protecting at least one other region (101a) from among the said regions (101a, 101b) of the upper surface of the substrate (100), the said posts after step b) comprising at least one part located in the substrate and surrounded by the said given semiconductor material;
c) forming a suspended element (140) on the top of the said post or posts.

2. The method according to claim 1, wherein said given region is partly or entirely surrounded by one or more said posts.

3. The method according to one of claims 1 or 2, wherein at least one post is arranged between two of said regions.

4. The method according to any of claims 1 to 3, wherein the said posts are regularly distributed and arranged in an array.

5. The method according to one of claims 1 to 4, wherein step a) comprises steps of:
- etching the upper surface of the substrate (100) so as to form semiconductor blocks;
- forming posts contiguous with said semiconductor blocks.

6. The method according to claim 5, the forming of said posts at step a) comprising steps of:
- conformal deposition of insulating material on and around said semiconductor blocks;
- removal of insulating material in a region located above the semiconductor blocks;
step b) comprising the etching of all or part of the semiconductor blocks to form said regions.

7. The method according to claim 6, wherein the forming of said insulating posts comprises steps of:
- etching the upper surface of the substrate (100) to form semiconductor blocks, the semiconductor blocks being covered by an oxidation mask (303a, 303b);
- oxidizing the given semiconductor material of the substrate (100).

8. The method according to one of claims 1 to 7, wherein the forming of said insulating posts comprises the etching of an insulating layer resting on the substrate, so as to define insulating posts resting on the substrate (100).

9. The method according to one of claims 1 to 8, the substrate forming a first electrode or comprising a first electrode, the suspended element forming a second electrode or comprising a second electrode.

10. The method according to one of claims 1 to 9, the device being a NEMS/MEMS.

11. The method according to one of claims 1 to 10, the device being a cMUT transducer.

12. The method according to one of claims 1 to 11, wherein step c) to form the suspended element comprises the transfer by direct bonding of a membrane onto the said posts.

13. The method according to claim 12, wherein the membrane is thinned after transfer.

14. The method according to any one of claims 1 to 13, wherein the addition of material comprises epitaxial growth of semiconductor material.
